# EUROPEAN PATENT APPLICATION

(11) **EP 4 697 904 A1**
(43) Date of publication of application: **18.02.2026**
(21) Application number: 25795384.4
(22) Date of filing: 30.05.2025
(51) Int. Cl.: H10H 20/831, H10H 20/819, H10H 20/85, H10H 20/857, H10H 20/84, H10H 20/855, H10H 20/00

(54) **ULTRAVIOLET LIGHT-EMITTING SEMICONDUCTOR CHIP AND ULTRAVIOLET LIGHT-EMITTING SEMICONDUCTOR LIGHT-EMITTING DEVICE COMPRISING SAME**

(30) Priority: 05.06.2024 KR 20240073660; 10.07.2024 KR 20240090823
(71) Applicant: ELPHOTON INC., Yongin-si, Gyeonggi-do 16976 (KR)
(72) Inventor: JEON, Soo Kun, Seongnam-si, Gyeonggi-do 13588 (KR); PARK, Eun Hyun, Seongnam-si, Gyeonggi-do 13599 (KR); KIM, Woo Hyun, Hwaseong-si, Gyeonggi-do 18416 (KR)
(74) Representative: Robba, Pierpaolo
(86) International application number: PCT/KR2025/007414
(87) International publication number: WO 2025/254393

(57) **Abstract**

The present disclosure relates to a UV light emitting semiconductor chip and a UV light emitting semiconductor device including the UV light emitting semiconductor chip. The UV light emitting semiconductor chip includes: a transparent substrate; a plurality of semiconductor regions provided on the transparent substrate and including a first semiconductor region, a second semiconductor region, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; a first electrode provided on an exposed first semiconductor region, which is formed by partially removing the second semiconductor region, the active region, and the first semiconductor region, and electrically connected to the first semiconductor region; and a second electrode electrically connected to the second semiconductor region, wherein the first electrode has a closed-loop shape and surrounds the mesa region when the first electrode and the second electrode are seen from above, in order to block moisture and gas.

## Description

### [Technical Field]

The present disclosure generally relates to a UV light emitting semiconductor chip and a semiconductor light emitting device with the same, and more particularly, to a UV light emitting semiconductor chip that can protect a semiconductor chip from external gas, including moisture and air, and a semiconductor light emitting device including the UV light emitting semiconductor chip. Here, the UV light emitting semiconductor chip refers to a semiconductor optical device that generates ultraviolet light (with an emission peak wavelength of 400 nm or less, particularly 300 nm or less) through recombination of electrons and holes, and may be made of a group III nitride semiconductor (Al(x)Ga(y)In(1-x-y)N (0≤x≤1, 0≤y≤1, 0≤x+y≤1)).

### [Background Art]

This section provides background information related to the present disclosure which is not necessarily prior art.

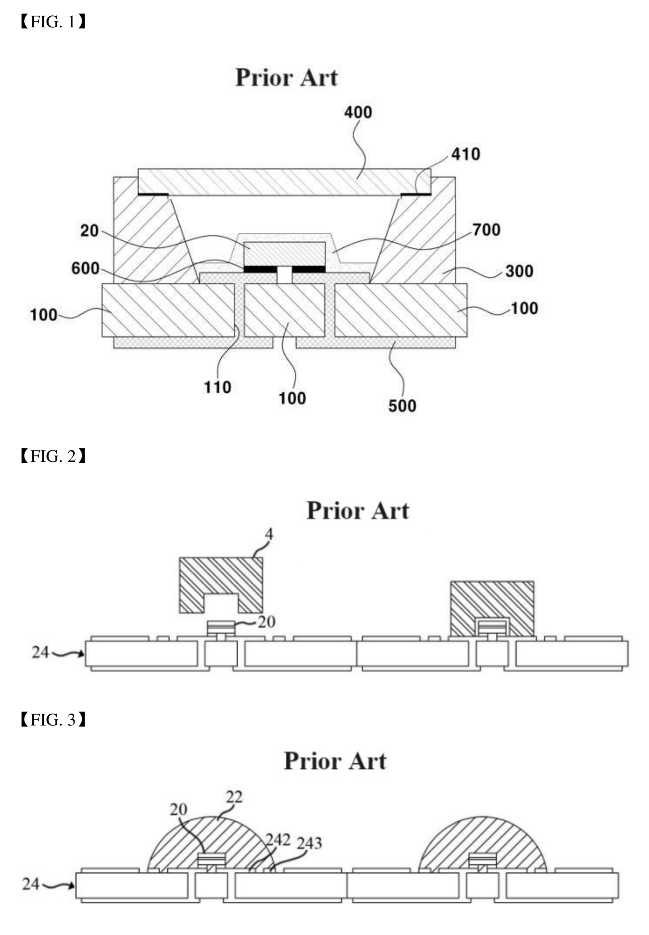

FIG. 1 is a view illustrating an example of a UV light emitting semiconductor device disclosed in Korean Patent No. 10-2347997, and the light emitting device includes a supporting substrate 100 and a UV light emitting semiconductor chip 20. The supporting substrate 100 has a via hole 100 and a reflective wall 300, the via hole 100 has a conductive portion or a conductive layer 500 electrically connected to the semiconductor chip 20, and a transparent cover 400 is attached to the reflective wall 300 through an adhesive 410. An encapsulant 700 is additionally formed in a space formed by the reflective wall 300 and the transparent cover 400, and the encapsulant 700 serves to protect the semiconductor chip 20 from gas such as moisture and/or oxygen that can penetrate the space despite the transparent cover 400. The reference numeral 600 not described denotes solder and is used for bonding the supporting substrate 100 and the semiconductor chip 200.

FIGS. 2 and 3 are views illustrating an example of a method of manufacturing a UV light emitting semiconductor device disclosed in U.S. Patent No. US11,824,148, and as illustrated in FIG. 2, a semiconductor chip 20 is attached to a supporting substrate 24, and then a solid lens material 4 made of a thermosetting resin is placed on top of it. Next, as illustrate in FIG. 3, the lens material 4 is formed through thermal curing into a lens or an encapsulant 22 having a desired shape. The reference numeral 242 not state above denotes a conductive portion or a conductive layer, and the reference numeral 243 not described is a stopper layer that serves as a stopper for the lens material 4 during a thermal curing process. Through this configuration (i.e., a configuration in which the reflective wall 300 and the transparent cover 400 are omitted, unlike the light emitting device presented in FIG. 1), it is possible to reduce optical loss of about 10~15% occurring during the process in which light generated from the semiconductor chip 20 is emitted to the outside of the light emitting device through the space between the reflective wall 300 and the cover material 400 and the transparent cover 400 (e.g., quartz, sapphire), and the process of attaching the transparent cover 400 to the reflective wall 300, which is a complicated process, can be omitted.

However, a more reliable means for preventing the penetration of gas such as moisture and/or oxygen, which may be critical to the performance of the semiconductor chip 20, into the semiconductor chip 20.

### [Disclosure]

### [Technical Problem]

In this regard, it is described at the end of the "Detailed Description of the Invention".

### [Technical Solution]

This section provides a general summary of the disclosure and is not a comprehensive disclosure of its full scope or all of its features.

According to one aspect of the present disclosure, there is provided a UV light emitting semiconductor chip including: a transparent substrate; a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; a first electrode provided on an exposed first semiconductor region, which is formed by partially removing the second semiconductor region, the active region, and the first semiconductor region, and electrically connected to the first semiconductor region; and a second electrode electrically connected to the second semiconductor region, wherein the first electrode has a closed-loop shape and surrounds the mesa region when the first electrode and the second electrode are seen from above, in order to block moisture and gas.

According to another aspect of the present disclosure, there is provided a UV light emitting semiconductor chip including: a transparent substrate; a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; a first electrode provided on an exposed first semiconductor region, which is formed by partially removing the second semiconductor region, the active region, and the first semiconductor region, and electrically connected to the first semiconductor region; a second electrode electrically connected to the second semiconductor region; and a blocking wall having a closed-loop shape and surrounding the mesa region at the periphery of the first electrode when the first electrode and the second electrode are seen from above, in order to block moisture and gas.

According to another aspect of the present disclosure, a UV light emitting semiconductor device including the UV light emitting semiconductor chip is provided. The UV light emitting semiconductor device includes: a supporting substrate coupled to the semiconductor such that the first electrode and the second electrode face the supporting substrate, wherein the supporting substrate has a first conductive portion coupled to the first electrode and a second conductive portion coupled to the second electrode.

According to another aspect of the present disclosure, there is provided a UV light emitting semiconductor chip including: a transparent substrate; a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; an insulating layer surrounding the mesa region; a first electrode electrically communicating with the first semiconductor region through the insulating layer, and having a first bonding layer on the insulating layer; and a second electrode electrically communicating with the second semiconductor region through the insulating layer, and having a second bonding layer on the insulating layer, wherein one electrode of the first electrode and the second electrode surrounds the remaining electrode while forming a closed loop, and the one electrode forming the closed loop protects the active region emitting UV light from moisture and harmful gas together with the insulating layer.

### [Advantageous Effects]

In this regard, it is described at the end of the "Detailed Description of the Invention".

### [Description of Drawings]

FIG. 1 is a view illustrating an example of a UV light emitting semiconductor device disclosed in Korean Patent No. 10-2347997.
FIGS. 2 and 3 are views illustrating an example of a method of manufacturing a UV light emitting semiconductor device disclosed in U.S. Patent No. US11,824,148.
FIGS. 4 to 7 are views illustrating an example of a UV light emitting semiconductor chip and a semiconductor light emitting device including the UV light emitting semiconductor chip according to the present disclosure.
FIG. 8 is a view illustrating another example of a UV light emitting semiconductor chip according to the present disclosure.
FIG. 9 is a view illustrating another example of a UV light emitting semiconductor chip according to the present disclosure.
FIGS. 10 and 11 are views illustrating another example of a UV light emitting semiconductor chip according to the present disclosure.
FIGS. 12 and 13 are views illustrating another example of a supporting substrate according to the present disclosure.
FIG. 14 is a view illustrating another example of a supporting substrate according to the present disclosure.
FIG. 15 is a view illustrating another example of a UV light emitting semiconductor chip according to the present disclosure.
FIG. 16 is a view illustrating another example of a UV light emitting semiconductor chip according to the present disclosure.
FIG. 17 is a view illustrating another example of a UV light emitting semiconductor chip and a semiconductor light emitting device including the UV light emitting semiconductor chip according to the present disclosure.
FIG. 18 is a view illustrating another example of a UV light emitting semiconductor chip and a semiconductor light emitting device including the UV light emitting semiconductor chip according to the present disclosure.
FIG. 19 is a view illustrating another example of a UV light emitting semiconductor chip and a semiconductor light emitting device including the UV light emitting semiconductor chip according to the present disclosure.
FIG. 20 is a view illustrating another example of a UV light emitting semiconductor chip and a semiconductor light emitting device including the UV light emitting semiconductor chip according to the present disclosure.
FIGS. 21 to 23 are views illustrating another example of a UV light emitting semiconductor chip according to the present disclosure.

### [Mode for Invention]

The present disclosure will now be described in detail with reference to the accompanying drawing(s).

FIGS. 4 to 7 are views illustrating an example of a UV light emitting semiconductor chip and a semiconductor light emitting device including the UV light emitting semiconductor chip according to the present disclosure, and the semiconductor light emitting device includes a semiconductor chip 20 and a supporting substrate or carrier 24, and, if necessary, may further include a lens or an encapsulant 22. In the presented example, for convenience of explanation, the semiconductor chip 20 and the supporting substrate 24 are separated, but they are coupled in actual devices, and soldering, paste, etc. may be used for the coupling.

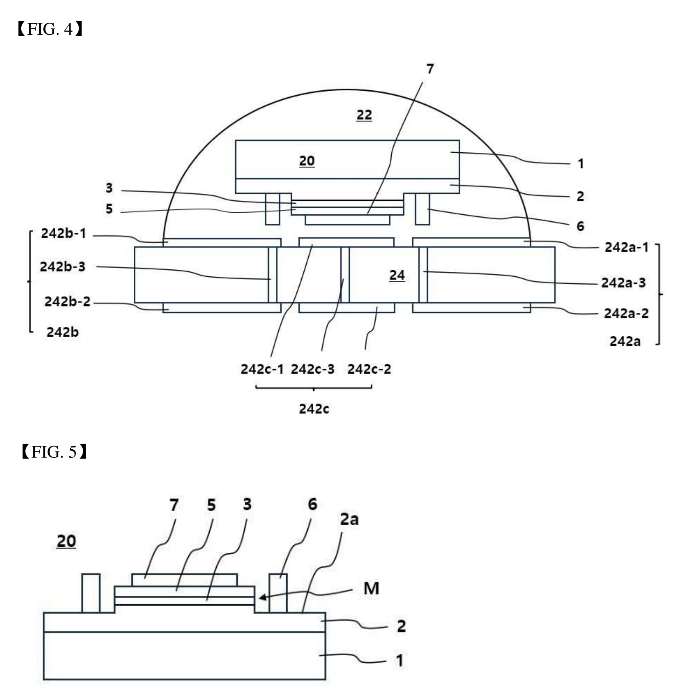

The semiconductor chip 20 includes, as illustrated in FIG. 5, a transparent substrate 1 (e.g., a growth substrate made of sapphire), a first semiconductor region 2 (e.g., an n-type group III nitride semiconductor), an active region 3 (a quantum well structure made of a group III nitride semiconductor), a second semiconductor region 5 (e.g., a p-type group III nitride semiconductor), a first electrode 6 being in electrical contact with the first semiconductor region 2, and a second electrode 7 being in electrical contact with the second semiconductor region 5. The active region 3 is interposed between the first semiconductor region 2 and the second semiconductor region 5, and emits ultraviolet light through the recombination of electrons and holes using a current that is supplied through the first electrode 6 and the second electrode 7. The first electrode 6 is positioned on a first semiconductor region 2a exposed around a mesa region M, which is formed by partially removing the second semiconductor region 5, the active region 3, and the first semiconductor region 2, and the second electrode 7 is formed over almost the entire upper surface of the second semiconductor region 5 and serving as a reflective film so that light generated in the active region 3 is emitted through the transparent substrate 1. It is common that a buffer region (not illustrated) for the growth of the high-quality semiconductor regions 2, 3, and 5 is provided between the transparent substrate 1 and the first semiconductor region 2.

FIG. 6 is a plan view of the semiconductor chip 20 view from the side where the electrodes 6 and 7 are positioned, and the first electrode 6 is formed on the first semiconductor region 2, that is, on the exposed first semiconductor region 2a, in a closed-loop shape surrounding the mesa region M while maintaining a distance from the mesa region M. Through this configuration, the mesa region M, where the active region 3 (see Figure 4) is positioned, is completely sealed while being coupled to the supporting substrate 24, and according, it is difficult for humidity, moisture, and/or harmful gas (chlorine, sulfur, oxygen, air) from the outside to enter, so the semiconductor chip 20 or the semiconductor light emitting device can stably operate. The first electrode 6 and the second electrode 7 may be separately formed, and photolithography and metal deposition processes may be used in each process.

Referring to FIG. 4, the supporting substrate or carrier 24 includes three conductive portions 242a, 242b, and 242c, based on the cross-sectional view. The three conductive portions 242a, 242b, and 242c, respectively may include top pads 242a-1, 242b-1, and 242c-1 that are directly bonded to the first electrode 6 and the second electrode 7, bottom pads 242a-2, 242b-2, and 242c-2 that are connected to an external power source, and connecting portions 242a-3, 242b-3, 242c-3 connecting the pads through the supporting substrate 24. Of course possible, though not preferable, the top pads and/or the bottom pads may be omitted. When the first electrode 6 has a closed-loop shape, two conductive portions 242a and 242b are integrally formed, and in this case, of course, one of the two connecting portions 242a-3 and 242b-3 may be omitted and the bottom pads 242a-2 and 242b-2 remain, and, of course, the bottom pad 242a-2 or 242b-2 with the connecting portion 242a-3 or 242b-3 omitted may be connected to the bottom pad 242c-2.

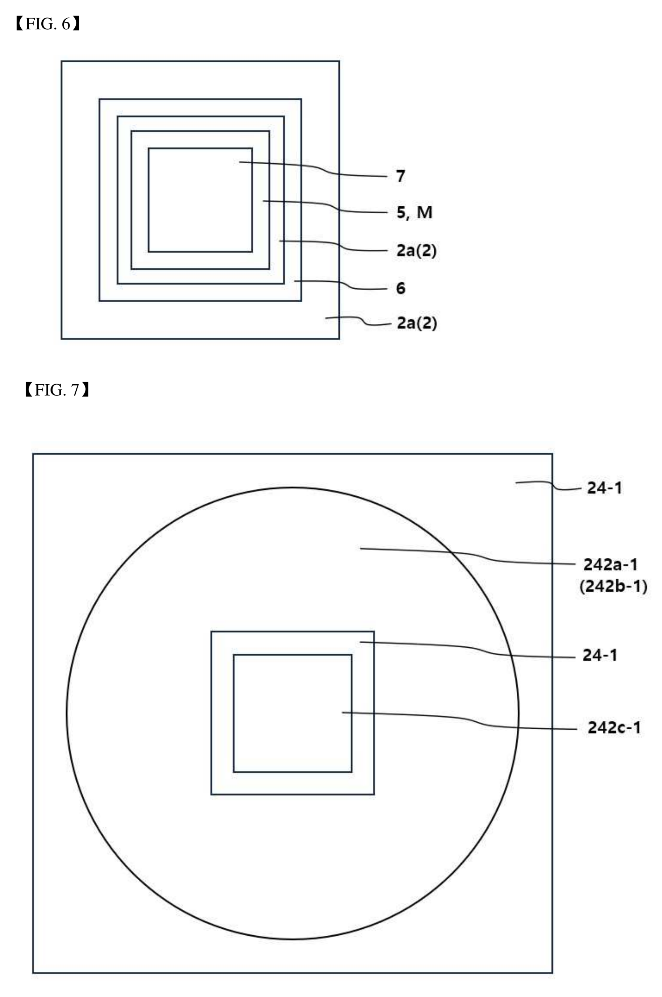

Further, by providing a lens or encapsulant 22, the protection of the semiconductor chip 20 from moisture and gas can be further ensured, and when the lens 22 is formed using the technique presented in FIGS. 2 and 3, as presented in FIG. 7, the two conductive portions 242a and 242b bonded to the first electrode 6 are integrally formed to have a single closed-loop shape (e.g., a hollow circular shape with a rectangular interior), whereby they can serve as a stopper during a thermal curing process of the lens 22. The reference numeral 24-1 not described denotes the upper surface of the supporting substrate 24.

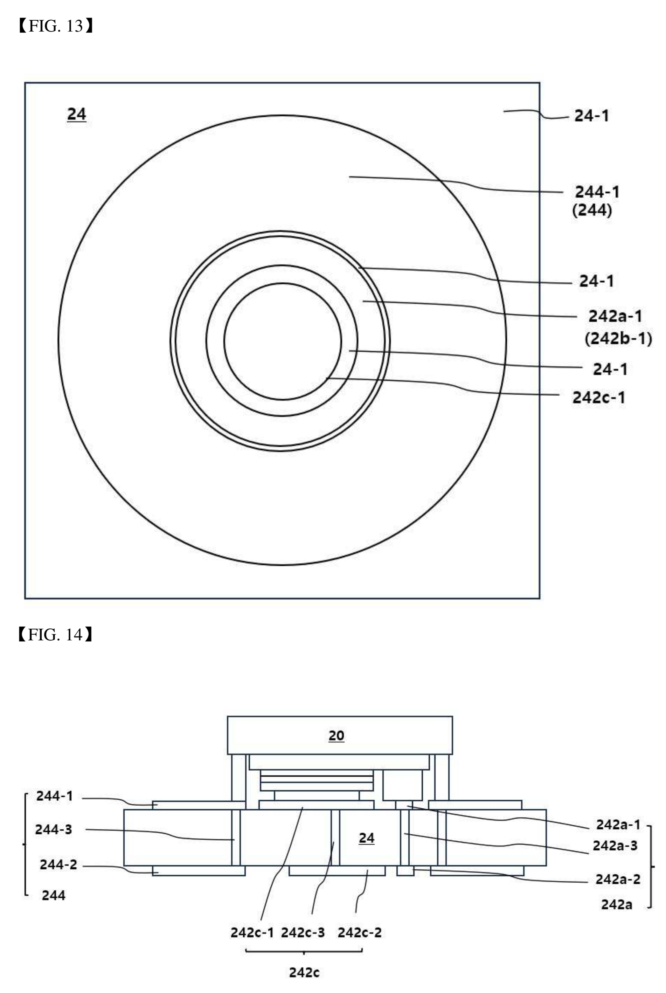

The first electrode 6 may be composed of multiple layers using a combination of Ti, Cr, Al, Ni, TiN, W, Pt, Rh, Au, Sn, or a solder containing Sn (AuSn, AgSn, CuSn, SnAgCu, NiSn, etc.), and the second electrode 7 may also be composed of multiple layers using a combination of ITO, Ti, Cr, Al, Ni, TiN, W, Pt, Rh, Au, Sn, or a solder containing Sn (AuSn, AgSn, CuSn, SnAgCu, NiSn, etc.). As illustrated in FIG. 15, when the first electrode 6 is composed of multiple layers (e.g., ohmic layer-bonding layer, ohmic layer-barrier layer-bonding layer), an ohmic layer 6-1 (dashed line) and a bonding layer 6-2 that are positioned at the lower portion and are respectively in ohmic contact with the first semiconductor region 2, 2a and bonded to the supporting substrate 25 may be separately formed. In this case, it is sufficient for only the bonding layer 6-2 to be formed in a closed-loop shape, and in the presented example, the bonding layer 6-2 covers the entire ohmic layer 6-1 in contact with the first semiconductor region 2, 2a.

FIG. 8 is a view illustrating another example of the UV light emitting semiconductor chip according to the present disclosure, in which the first semiconductor region 2 is removed, whereby the upper surface 1a of the transparent substrate 1 is exposed, and the first electrode 6 is formed across the exposed first semiconductor region 2a and the upper surface 1a of the transparent substrate 1. Through this configuration, it is possible to block the first semiconductor region 2 from coming into contact with moisture and/or gas, and it is possible to more securely couple the first electrode 6 to the semiconductor chip 20.

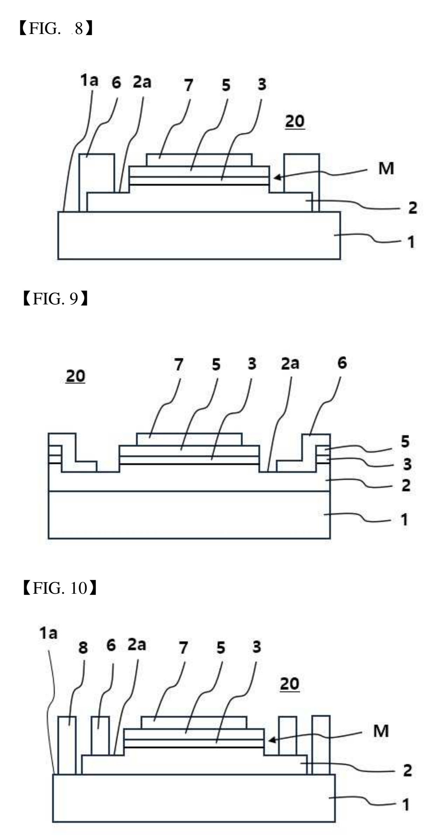

FIG. 9 is a view illustrating another example of the UV light emitting semiconductor chip according to the present disclosure, in which, in the process of exposing the first semiconductor region 2a (the process of forming the mesa region M (see FIG. 5)), the second semiconductor region 5 and the active region 3 at the edge side of the semiconductor chip 20 are left as they are, and the first electrode 6 is formed thereon. Through this configuration, the first electrode 6 and the second electrode 7 can be formed in a single process, and it is also easy to align the heights of the first electrode 6 and the second electrode 7.

FIGS. 10 and 11 are views illustrating another example of the UV light emitting semiconductor chip according to the present disclosure, in which, a blocking wall 8 functioning as a penetration barrier film is installed in a closed-loop shape on the exposed region 1a of the transparent substrate 1 separately from the first electrode 6. In this case, the first electrode 6 may have a closed-loop shape or may not (see FIG. 11). When the first electrode 6 has a closed-loop shape, blocking of moisture and/or gas can be made more reliable. The blocking wall 8 may be electrically isolated from the first electrode 6, or may not. The blocking wall 8 can be formed through the same process as the first electrode 6, and since it does not function as an electrode, it also has the advantage that it can be composed only of metal(s) effective for blocking moisture and/or gas, unlike the metal constituting the first electrode 6.

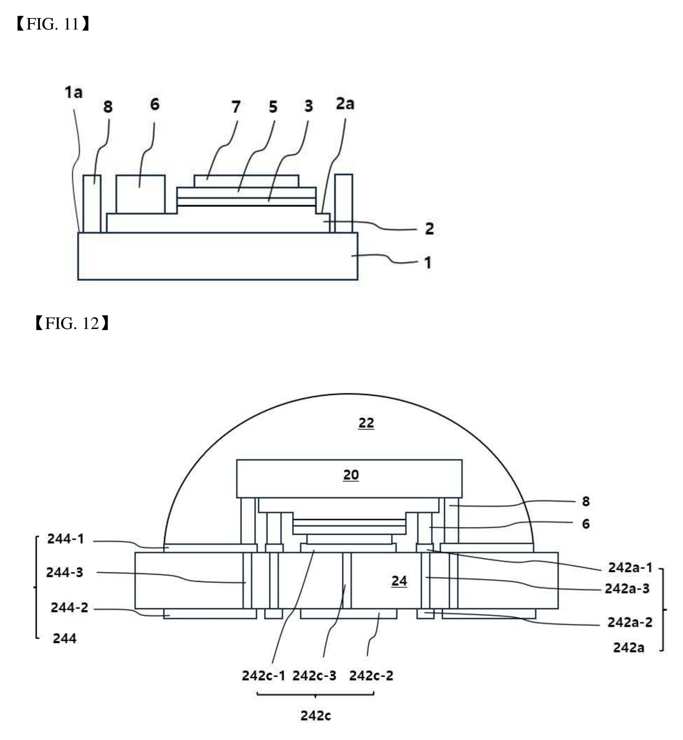

FIGS. 12 and 13 are views illustrating another example of the supporting substrate according to the present disclosure, in which the supporting substrate 24 illustrated in FIG. 12 corresponds to the semiconductor chip 20 presented in FIG. 10, and a blocking wall coupling portion 244 of a closed-loop shape (e.g., an annular ring (see FIG. 13)) that is coupled to the blocking wall 8 is formed. Preferably, the coupling portion 244 is composed of a top pad 244-1, a bottom pad 244-2, and a connecting portion 244-3 connecting the pads through the supporting substrate 24, whereby it is also possible to improve heat dissipation of the semiconductor chip 20 operating in a sealed space. Of course, the coupling portion 244 may be composed of only the top pad 244-1. The conductive portion 242a coupled to the first electrode 6 is electrically separated from the blocking wall coupling portion 244 and formed in the blocking wall coupling portion 244. When a lens or an encapsulant 22 is provided, the blocking wall coupling portion 244 also functions as a stopper for the lens material. Even when the semiconductor chip 20 presented in FIGS. 5, 8, and 9, in which the blocking wall 8 is not provided, is used, the blocking wall coupling portion 244 electrically separated from the conductive portions 242a and 242b can be provided and used as a stopper for the lens or the encapsulant 22.

FIG. 14 is a diagram illustrating another example of the supporting substrate according to the present disclosure, in which a supporting substrate 24 corresponding to the semiconductor chip 20 presented in FIG. 11 is presented. In this case, the conductive portion 242a coupled to the first electrode 6 does not form a closed loop.

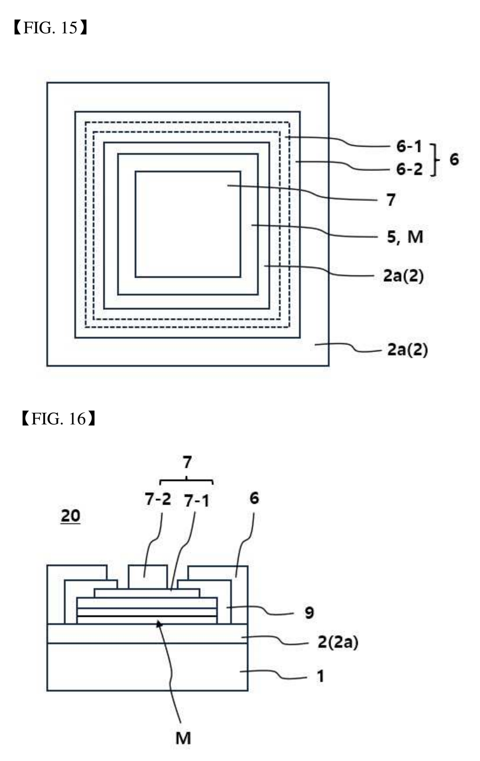

FIG. 16 is a view illustrating another example of the UV light emitting semiconductor chip according to the present disclosure, in which the first electrode 6 is electrically connected to the first semiconductor region 2, 2a with an insulating layer 9 interposed between the first electrode 6 and the mesa region M, and the first electrode 6 extends over the mesa region M. Similar to the first electrode 6 illustrate in FIG. 15, the second electrode 7 may separately include an ohmic layer 7-1 and a bonding layer 7-2, and the ohmic layer 7-1 may be formed before or after formation of the insulating layer 9. In addition, of course, a blocking wall 8 (see FIG. 10) may be provided, and the blocking wall 8 may be formed on the exposed sapphire substrate 1a or the exposed first semiconductor region 2a.

FIG. 17 is a view illustrating another example of the UV light emitting semiconductor chip and the semiconductor light emitting device including the UV light emitting semiconductor chip according to the present disclosure, in which the conductive portion 242 and the blocking wall coupling portion 244 are integrally formed. The first electrode 6 and the blocking wall 8 are coupled to the top pads 242-1 and 244-1, and the bottom pads 242-2, 244-2 do not surround the bottom pad 242c-2 (i.e., in a non-closed-loop shape), whereby versatility is provided for electrical connection with a commercially available external substrate. The connecting portions 242-3 and 244-3 connect the top pads 242-1 and 244-1 with the bottom pads 242-2 and 244-2, and descriptions of the same reference numerals not described are omitted. Of course, the lens 22 may be omitted. Of course, the top pad 242-1 and the top pad 244-1 may be formed independently and electrically separated rather than integrally.

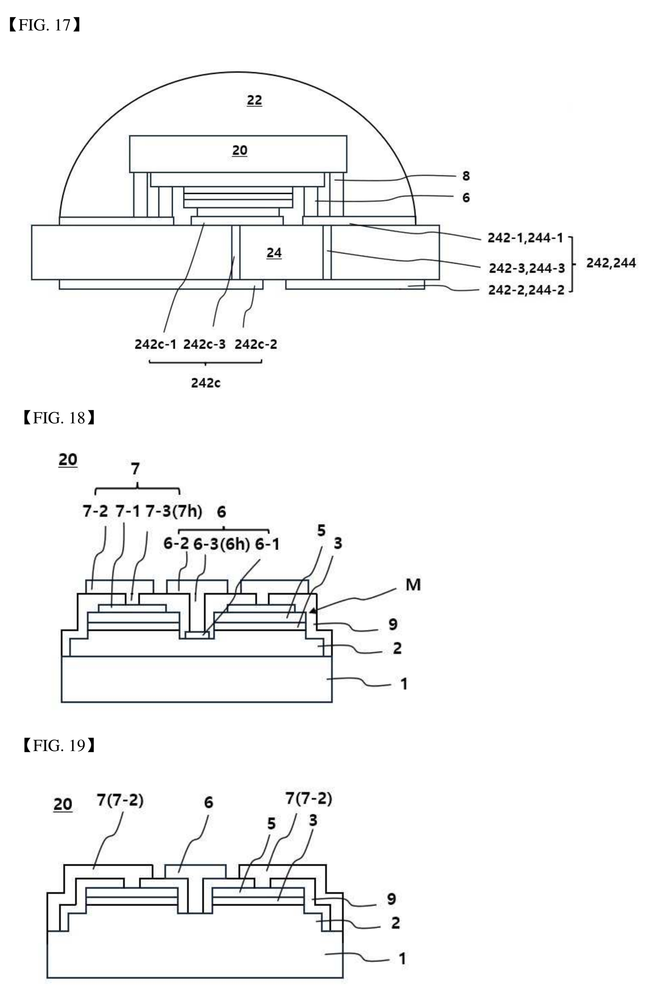

FIG. 18 is a view illustrating another example of the UV light emitting semiconductor chip according to the present disclosure, in which, compared to the example presented in FIG. 16, the positions of the first electrode 6 and the second electrode 7 are switched. That is, the second electrode 7 surrounds the first electrode 6 while forming a closed-loop. In the presented example, the first electrode 6 and the second electrode 7 are formed only over the insulating layer 9, and the sides of the mesa region M are protected from moisture and/or harmful gas by the insulating layer 9. An ohmic layer 6-1 and an ohmic layer 7-1 are formed on the first semiconductor region 2 and the second semiconductor region 5, respectively, and the ohmic layer 6-1 and the bonding layer 6-2 are electrically connected by the electrical connection 6-3 provided in a via hole 6h formed in the insulating layer 9, while the ohmic layer 7-1 and the bonding layer 7-2 are electrically connected by electrical connection 7-3 provided in a via hole 7h formed in the insulating layer 9. The ohmic layer 6-1, the bonding layer 6-2, and the electrical connection 6-3 constitute the first electrode 6, and the ohmic layer 7-1, the bonding layer 7-2, and the electrical connection 7-3 constitute the second electrode 7. The electrical connection 6-3 and the electrical connection 7-3 may be respectively formed in the via hole 6h and the via hole 7h during the formation process of the bonding layers 6-2 and 7-2.

FIG. 19 is a view illustrating another example of the UV light emitting semiconductor chip according to the present disclosure, in which, unlike the example presented in FIG. 18, the second electrode 7, in detail, the bonding layer 7-2 of the second electrode 7 extends to the substrate 1. Of course, the ohmic layer 6-1 and/or the ohmic layer 7-1 may be provided.

FIG. 20 is a view illustrating another example of the UV light emitting semiconductor chip according to the present disclosure, in which, in addition to the example presented in FIG. 19, a blocking wall 8 is formed.

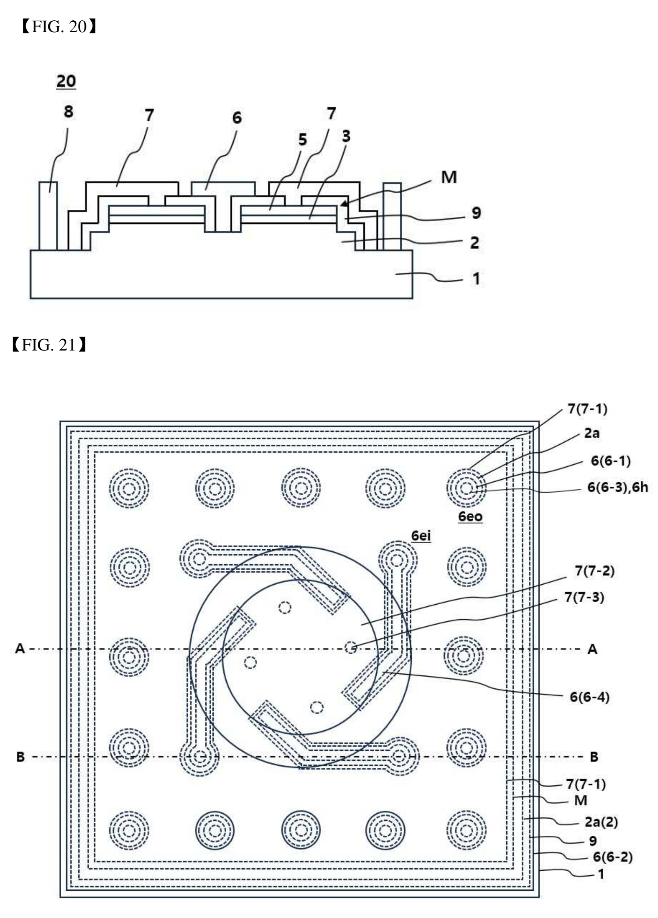

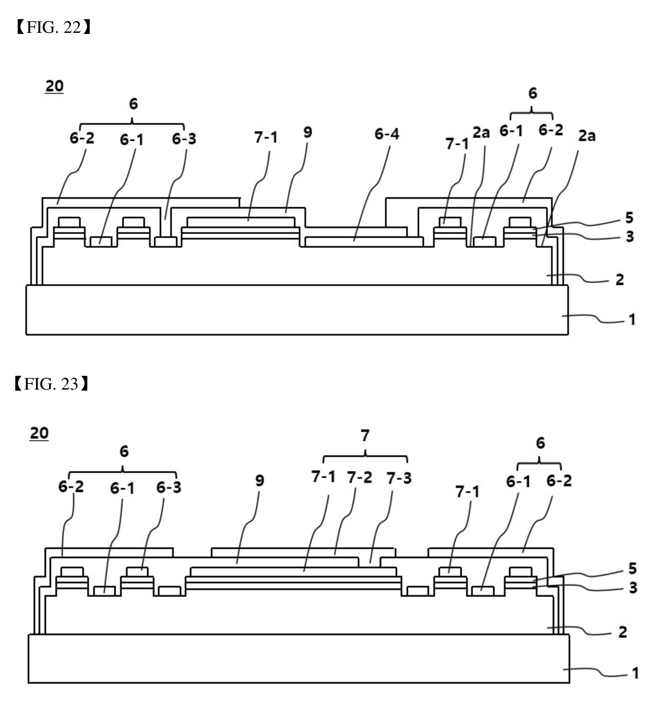

FIGS. 21 to 23 are views illustrating another example of the UV light emitting semiconductor chip according to the present disclosure, in which, this example is similar in configuration to the example presented in FIG. 19, but the positions of the first electrode 6 and the second electrode 7 are switched. FIG. 21 is a view of the device seen from the top, FIG. 22 is a cross-sectional view taken along line B-B of FIG. 21, and FIG. 23 is a cross-sectional view taken along line A-A of FIG. 21. One or more via holes 6h are used for the electrical connection or communication between the first electrode 6 (6-1, 6-2, 6-3) and the first semiconductor region 2 (2a). The mesa region M is completely covered by the insulating layer 9 and the first electrode 6 (6-2), so it is protected from moisture and gas, and the first electrode 6 (6-2) is not electrically connected to the first semiconductor region 2 at the periphery of the mesa region M. Of course, the outside of the mesa region M may have the form presented in FIG. 16. When the semiconductor chip 20 is increased in size, branch electrodes 6-4 may be provided to ensure smooth current supply into the device. The branch electrodes 6-4 refer to electrodes having a narrow and elongated shape and may be formed together with the ohmic layer 6-1 of the first electrode 6. In the presented example, the second electrode 7 (7-2) has a circular shape, and the first electrode 6 (6-2) is spaced apart from the second electrode 7 (7-2) and forms a circular hole therein. The branch electrodes 6-4 respectively extend from bonding layers 6ei positioned inside, and, when seen from above, the branch electrodes 6-4 extend down beneath the second electrode 7-2. Similar to the first electrode 6, the second electrode 7 is composed of an ohmic layer 7-1, a bonding layer 7-2, and one or more electrical connections 7-3, in which the ohmic layer 7-1 is formed over almost the entire front of the mesa region M on the second semiconductor region 5, and the one or more electrical connections 7-3 electrically connect the ohmic layer 7-1 and the bonding layer 7-2 inside the circular hole formed by the first electrode 6 (6-2). Depending on the size of the semiconductor chip 20, the bonding layer 6eo provided at the outer portion of the device may be omitted. Through this configuration, the device can be protected from moisture and gas by the insulating layer 9 and the first electrode 6 (6-2). Of course, a blocking wall 8 (see FIG. 20) may be provided.

Hereinafter, various embodiments of the present disclosure are described.
(1) A UV light emitting semiconductor chip, comprising: a transparent substrate; a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; a first electrode provided on an exposed first semiconductor region, which is formed by partially removing the second semiconductor region, the active region, and the first semiconductor region, and electrically connected to the first semiconductor region; and a second electrode electrically connected to the second semiconductor region, wherein the first electrode has a closed-loop shape and surrounds the mesa region when the first electrode and the second electrode are seen from above, in order to block moisture and gas.
(2) The UV light emitting semiconductor chip, wherein the transparent substrate is exposed by partially removing the second semiconductor region, the active region, and the first semiconductor region; and the first electrode is formed across the exposed transparent substrate and the exposed first semiconductor region.
(3) The UV light emitting semiconductor chip, wherein a portion of the second semiconductor region and the active region remains and is spaced apart from the mesa region, and the first electrode is formed across the remaining portion and the exposed first semiconductor region.
(4) The UV light emitting semiconductor chip, further comprising a blocking wall having a closed-loop shape and surrounding the mesa region and the first electrode having a closed-loop shape when the first electrode and the second electrode are seen from above, in order to block moisture and gas.
(5) The UV light emitting semiconductor chip, wherein the first electrode includes an ohmic layer, which is in ohmic contact with the first semiconductor region, and a bonding layer positioned on a top, and the bonding layer has a closed-loop shape.
(6) The UV light emitting semiconductor chip, further comprising an insulating layer interposed between the first electrode and the mesa region, wherein the first electrode has a closed-loop shape and extends over the mesa region on the insulating layer.
(7) A UV light emitting semiconductor chip, comprising: a transparent substrate; a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; a first electrode provided on an exposed first semiconductor region, which is formed by partially removing the second semiconductor region, the active region, and the first semiconductor region, and electrically connected to the first semiconductor region; a second electrode electrically connected to the second semiconductor region; and a blocking wall having a closed-loop shape and surrounding the mesa region at the periphery of the first electrode when the first electrode and the second electrode are seen from above, in order to block moisture and gas.
(8) A UV light emitting semiconductor device that comprises the semiconductor chip of the present disclosure, comprising a supporting substrate coupled to the semiconductor chip such that the first electrode and the second electrode face the supporting substrate, wherein the supporting substrate has a first conductive portion coupled to the first electrode and a second conductive portion coupled to the second electrode.
(9) The UV light emitting semiconductor device, further comprising a lens formed on the supporting substrate and covering the semiconductor chip, wherein the first conductive portion has a closed-loop shape to function as a stopper providing surface tension during formation of the lens.
(10) The UV light emitting semiconductor device, wherein the semiconductor chip includes a blocking wall that is positioned at the periphery of the first electrode while surrounding the mesa region when the first electrode and the second electrode are seen from above, in order to block moisture and gas, and has a closed-loop shape, and the UV light emitting semiconductor device further includes a blocking wall coupling portion having a closed-loop shape at the periphery of the first conductive portion and coupled to the blocking wall.
(11) The UV light emitting semiconductor device, further comprising a lens formed on the supporting substrate and covering the semiconductor chip, wherein moisture and gas are blocked by the blocking wall having a closed-loop shape, the blocking wall coupling portion having a closed-loop shape, and the lens of which the shape is determined by the blocking wall coupling portion.
(12) The UV light emitting semiconductor device, wherein the semiconductor chip includes a blocking wall that is positioned at the periphery of the first electrode while surrounding the mesa region when the first electrode and the second electrode are seen from above, in order to block moisture and gas, and has a closed-loop shape; the UV light emitting semiconductor device further includes a blocking wall coupling portion having a closed-loop shape at the periphery of the first conductive portion and coupled to the blocking wall; the first conductive portion includes a top pad provided on an upper surface of the supporting substrate and coupled to the first electrode, a bottom pad provided on a lower surface of the supporting substrate, and a connecting portion connecting the top pad and the bottom pad through the supporting substrate; the blocking wall coupling portion includes a top pad provided on the upper surface of the supporting substrate and coupled to the blocking wall, a bottom pad provided on the lower surface of the supporting substrate, and a connecting portion connecting the top pad and the bottom pad through the supporting substrate; and the bottom pad of the first conductive portion and the bottom pad of the blocking wall coupling portion are integrally formed without forming a closed loop.
(13) The UV light emitting semiconductor device, wherein the top pad of the first conductive portion and the top pad of the blocking wall coupling portion are integrally formed while forming a closed loop.
(14) A UV light emitting semiconductor chip, comprising: a transparent substrate; a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region; an insulating layer surrounding the mesa region; a first electrode electrically communicating with the first semiconductor region through the insulating layer, and having a first bonding layer on the insulating layer; and a second electrode electrically communicating with the second semiconductor region through the insulating layer, and having a second bonding layer on the insulating layer, wherein one electrode of the first electrode and the second electrode surrounds the remaining electrode while forming a closed loop, and the one electrode forming the closed loop protects the active region emitting UV light from moisture and harmful gas together with the insulating layer.
(15) The UV light emitting semiconductor chip, wherein the one electrode forming the closed loop covers the insulating layer on a side of the mesa region.
(16) The UV light emitting semiconductor chip, wherein the remaining electrode includes an ohmic layer and one or more electrical connections connecting the ohmic layer and a bonding layer, the one electrode forming the closed loop has a hole therein at a distance from the remaining electrode, and the one or more electrical connections are positioned in the hole of the one electrode forming the closed loop.
(17) The UV light emitting semiconductor chip of claim 16, wherein the one electrode forming the closed loop includes an ohmic layer and branch electrodes extending from the ohmic layer, and the branch electrodes extend beneath the bonding layer of the remaining electrode when seen from above.

According to one UV light emitting semiconductor chip and a semiconductor light emitting device including the UV light emitting semiconductor chip according to the present disclosure, it is possible to protect a semiconductor chip from external gas, including moisture and air.

According to another UV light emitting semiconductor chip and a semiconductor light emitting device including the UV light emitting semiconductor chip according to the present disclosure, it is possible to reduce light loss generated as UV light passes through the space between a reflecting wall and a transparent cover and through the transparent cover.

According to another UV light emitting semiconductor chip and a semiconductor light emitting device including the UV light emitting semiconductor chip according to the present disclosure, the ohmic layer facilitates current supply to the device and it is possible to block the inflow of gas and/or moisture using the bonding layer. That is, despite the functional constraints of a bonding layer, current supply to the device can be facilitated.

## Claims

1. A UV light emitting semiconductor chip, comprising:
a transparent substrate;
a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region;
a first electrode provided on an exposed first semiconductor region, which is formed by partially removing the second semiconductor region, the active region, and the first semiconductor region, and electrically connected to the first semiconductor region; and
a second electrode electrically connected to the second semiconductor region,
wherein the first electrode has a closed-loop shape and surrounds the mesa region when the first electrode and the second electrode are seen from above, in order to block moisture and gas.

2. The UV light emitting semiconductor chip of claim 1, wherein the transparent substrate is exposed by partially removing the second semiconductor region, the active region, and the first semiconductor region; and
the first electrode is formed across the exposed transparent substrate and the exposed first semiconductor region.

3. The UV light emitting semiconductor chip of claim 1, wherein a portion of the second semiconductor region and the active region remains and is spaced apart from the mesa region, and
the first electrode is formed across the remaining portion and the exposed first semiconductor region.

4. The UV light emitting semiconductor chip of claim 1, further comprising a blocking wall having a closed-loop shape and surrounding the mesa region and the first electrode having a closed-loop shape when the first electrode and the second electrode are seen from above, in order to block moisture and gas.

5. The UV light emitting semiconductor chip of claim 1, wherein the first electrode includes an ohmic layer, which is in ohmic contact with the first semiconductor region, and a bonding layer positioned on a top, and the bonding layer has a closed-loop shape.

6. The UV light emitting semiconductor chip of claim 1, further comprising an insulating layer interposed between the first electrode and the mesa region,
wherein the first electrode has a closed-loop shape and extends over the mesa region on the insulating layer.

7. A UV light emitting semiconductor chip, comprising:
a transparent substrate;
a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region;
a first electrode provided on an exposed first semiconductor region, which is formed by partially removing the second semiconductor region, the active region, and the first semiconductor region, and electrically connected to the first semiconductor region;
a second electrode electrically connected to the second semiconductor region; and
a blocking wall having a closed-loop shape and surrounding the mesa region at the periphery of the first electrode when the first electrode and the second electrode are seen from above, in order to block moisture and gas.

8. A UV light emitting semiconductor device that comprises the semiconductor chip of any one of claims 1 to 7, comprising a supporting substrate coupled to the semiconductor chip such that the first electrode and the second electrode face the supporting substrate,
wherein the supporting substrate has a first conductive portion coupled to the first electrode and a second conductive portion coupled to the second electrode.

9. The UV light emitting semiconductor device of claim 8, further comprising a lens formed on the supporting substrate and covering the semiconductor chip,
wherein the first conductive portion has a closed-loop shape to function as a stopper providing surface tension during formation of the lens.

10. The UV light emitting semiconductor device of claim 8, wherein the semiconductor chip includes a blocking wall that is positioned at the periphery of the first electrode while surrounding the mesa region when the first electrode and the second electrode are seen from above, in order to block moisture and gas, and has a closed-loop shape, and
the UV light emitting semiconductor device further includes a blocking wall coupling portion having a closed-loop shape at the periphery of the first conductive portion and coupled to the blocking wall.

11. The UV light emitting semiconductor device of claim 10, further comprising a lens formed on the supporting substrate and covering the semiconductor chip,
wherein moisture and gas are blocked by the blocking wall having a closed-loop shape, the blocking wall coupling portion having a closed-loop shape, and the lens of which the shape is determined by the blocking wall coupling portion.

12. The UV light emitting semiconductor device of claim 8, wherein the semiconductor chip includes a blocking wall that is positioned at the periphery of the first electrode while surrounding the mesa region when the first electrode and the second electrode are seen from above, in order to block moisture and gas, and has a closed-loop shape;
the UV light emitting semiconductor device further includes a blocking wall coupling portion having a closed-loop shape at the periphery of the first conductive portion and coupled to the blocking wall;
the first conductive portion includes a top pad provided on an upper surface of the supporting substrate and coupled to the first electrode, a bottom pad provided on a lower surface of the supporting substrate, and a connecting portion connecting the top pad and the bottom pad through the supporting substrate;
the blocking wall coupling portion includes a top pad provided on the upper surface of the supporting substrate and coupled to the blocking wall, a bottom pad provided on the lower surface of the supporting substrate, and a connecting portion connecting the top pad and the bottom pad through the supporting substrate; and
the bottom pad of the first conductive portion and the bottom pad of the blocking wall coupling portion are integrally formed without forming a closed loop.

13. The UV light emitting semiconductor device of claim 12, wherein the top pad of the first conductive portion and the top pad of the blocking wall coupling portion are integrally formed while forming a closed loop.

14. A UV light emitting semiconductor chip, comprising:
a transparent substrate;
a plurality of semiconductor regions provided on the transparent substrate and including a first semiconductor region having a first conductivity, a second semiconductor region having a second conductivity different from the first conductivity, and an active region interposed between the first semiconductor region and the second semiconductor region and configured to emit ultraviolet light through recombination of electrons and holes, wherein a mesa region is formed by partially removing the second semiconductor region, the active region, and the first semiconductor region;
an insulating layer surrounding the mesa region;
a first electrode electrically communicating with the first semiconductor region through the insulating layer, and having a first bonding layer on the insulating layer; and
a second electrode electrically communicating with the second semiconductor region through the insulating layer, and having a second bonding layer on the insulating layer,
wherein one electrode of the first electrode and the second electrode surrounds the remaining electrode while forming a closed loop, and the one electrode forming the closed loop protects the active region emitting UV light from moisture and harmful gas together with the insulating layer.

15. The UV light emitting semiconductor chip of claim 14, wherein the one electrode forming the closed loop covers the insulating layer on a side of the mesa region.

16. The UV light emitting semiconductor chip of claim 15, wherein the remaining electrode includes an ohmic layer and one or more electrical connections connecting the ohmic layer and a bonding layer,
the one electrode forming the closed loop has a hole therein at a distance from the remaining electrode, and
the one or more electrical connections are positioned in the hole of the one electrode forming the closed loop.

17. The UV light emitting semiconductor chip of claim 16, wherein the one electrode forming the closed loop includes an ohmic layer and branch electrodes extending from the ohmic layer, and
the branch electrodes extend beneath the bonding layer of the remaining electrode when seen from above.
